(19) Europäisches Patentamt
European Patent Office
Office européen des brevets

(11) **EP 1 739 831 A1**

(12) **DEMANDE DE BREVET EUROPEEN**

(43) Date de publication:
**03.01.2007 Bulletin 2007/01**

(51) Int Cl.:
*H03H 9/64* (2006.01)   *H03H 9/58* (2006.01)

(21) Numéro de dépôt: **06368010.2**

(22) Date de dépôt: **19.06.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **01.07.2005 FR 0507037**

(71) Demandeur: **STMicroelectronics S.A.**
**92120 Montrouge (FR)**

(72) Inventeurs:
• **Carpentier, Jean-Francois**
  **38100 Grenoble (FR)**
• **Tilhac, Cyrille**
  **19370 Soudaine Lavinadiere (FR)**

(74) Mandataire: **Schuffenecker, Thierry**
**97, Chemin de Cassiopée**
**Domaine de l'étoile**
**06610 La Gaude (FR)**

(54) **Circuit de filtrage passe-bande doté de résonateurs acoustiques**

(57)    Un circuit de filtrage passe-bande basé sur un quadripôle comportant :
- une branche série comportant un premier résonateur acoustique (120) présentant une fréquence de résonance et une fréquence d'antirésonance et monté en série avec un premier condensateur (110) ;
- une branche parallèle comportant un second résonateur acoustique (130) résultant du même procédé de fabrication que ledit premier résonateur et monté en parallèle avec un second condensateur (140) de valeur identique audit premier condensateur (110).

Le circuit de filtrage est particulièrement adapté à la réalisation de circuit de filtrage intégrés pour la téléphonie mobile.

Fig. 5

## Description

## Domaine technique de l'invention

La présente invention concerne les circuits électroniques et notamment un circuit de filtrage passe-bande doté de résonateurs acoustiques.

## Etat de la technique

Les résonateurs acoustiques sont aujourd'hui très répandus dans les applications grand-public mais également dans les applications professionnelles en raison de leur grande efficacité, notamment pour la réalisation de filtres passe-bandes très performants, et ce notamment en téléphonie mobile pour la sélection des canaux de transmission.

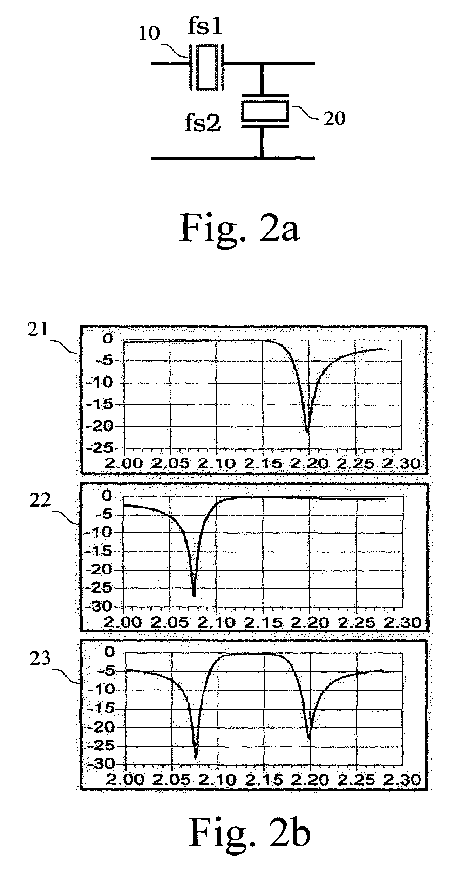

Une manière classique de réaliser un filtre passe-bande consiste à utiliser deux résonateurs acoustiques qui présentent des caractéristiques légèrement décalées, et à les monter en série /parallèle de manière à constituer une cellule de filtrage élémentaire. La figure 2a illustre un tel circuit connu où l'on voit un premier résonateur 10 (fs1) monté en série et un second résonateur 20 (fs2) en parallèle au sein d'un même quadripôle. La figure 2b illustre les courbes caractéristiques de chacun de ces résonateurs et la courbe du filtre passe-bande en résultant.

De cette manière on parvient à réaliser un filtre passe-bande particulièrement étroit et sélectif, que l'on pourra ensuite combiner avec d'autres cellules élémentaires pour réaliser un filtre plus complexe.

Les recherches ont porté sur deux types de résonateurs acoustiques qui présentent des performances remarquables, à savoir les résonateurs de type SAW *(Surface Acoustic Resonator)* et, plus récemment, ceux de type BAW (*Bulk Acoustic Resonator).* Dans les premiers, le résonateur acoustique est situé sur la surface d'un produit semiconducteur tandis que, dans les seconds, il est disposé à l'intérieur d'un volume délimité entre une électrode inférieure et une électrode supérieure en sorte que l'onde acoustique se développe dans ce même volume. Les résonateurs de type BAW font l'objet d'intenses recherches par les fabricants de produits semi-conducteurs car ces composants permettent d'envisager une intégration très poussée des circuits de filtrage et, par conséquent, laissent entrevoir une baisse significative du coût de fabrication de ces mêmes circuits.

Pour autant, il reste que la réalisation d'un filtre acoustique comportant deux résonateurs ayant des caractéristiques légèrement décalées est particulièrement délicate en raison des contraintes pesant sur la précision du procédé de fabrication. En effet, il faut pouvoir réaliser, pour chaque cellule de filtrage, non pas un résonateur mais un ensemble de deux résonateurs dont chacun présente des caractéristiques précises afin d'assurer un décalage en fréquence convenable permettant l'obtention de la courbe désirée. La précision exigée pour obtenir de telles caractéristiques impose le recours à des étapes particulièrement critiques au sein du procédé de fabrication du produit semi-conducteur dans lequel sera intégré le filtre passe-bande. Plus particulièrement, il faudra envisager le fabrication de deux résonateurs identiques, puis une étape de « surcharge » de l'un des deux résonateurs (*overloading* dans la littérature anglo-saxonne).

Concrètement, on décale les fréquences de résonance en venant ajouter une couche par dessus l'électrode supérieure. On effectue ensuite un traitement postérieur de type « trimming » par ablation laser, laquelle intervient après passivation de ce circuit. Ce procédé comporte l'inconvénient de ce qu'il ne permet pas de corriger individuellement chacun des résonateur car le faisceau laser est trop large. On ne peut donc corriger que de manière plus ou moins uniforme l'ensemble des résonateurs du filtre sans savoir l'effet produit sur chaque résonateur individuellement ; chargée ou non.

De telles opérations sont complexes, délicates et coûteuses à mettre en oeuvre.

Pour éviter la contrainte sur le procédé de fabrication, on pourrait envisager l'emploi de résonateurs BAW de type accordable, permettant de venir jouer, une fois le composant réalisé, sur les caractéristiques de ce dernier. La demande de brevet français 03 15480 intitulée « Résonateur acoustique intégrable, et procédé d'intégration d'un tel résonateur », déposée le 29. Décembre 2003 et non publiée à la date de dépôt de cette demande décrit la réalisation d'un *Composant Résonateur Réglable* (CRR) comportant un résonateur de type BAW auquel on associe une inductance, judicieusement choisie dans un voisinage d'une des fréquences de résonances, et une capacité variable permettant de décaler et de corriger la fréquence globale du résonateur.

Cette technique , si elle représente déjà une avancée significative dans la voie de l'intégration des résonateurs de type BAW dans un même circuit intégré, n'est pas directement utilisable dans la réalisation d'un filtre passe-bande simple et bon marché. On notera à cet égard l'espace considérablement occupé par les inductances exigées pour la mise en oeuvre de cette technique.

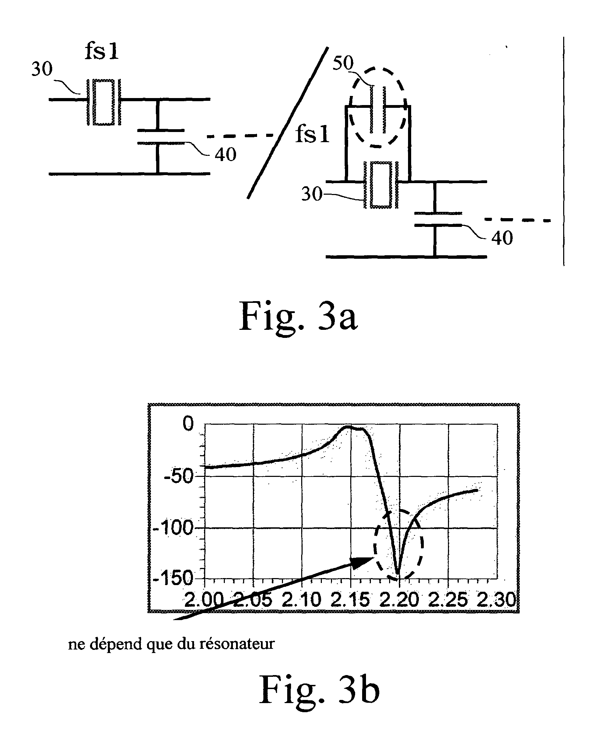

Dans d'autres circuits connus, on évite la difficulté en éliminant purement et simplement l'un des deux résonateurs du quadripôle de filtrage et en lui substituant un condensateur comme on le voit dans la figure 3a qui montre un tel circuit connu, comportant un résonateur 30 (fs1) monté dans la branche série du quadripôle, et associée à une capacité 40 située dans la branche parallèle. Dans certains cas, comme on le voit également sur la figure, pour améliorer la réjection, on dispose en outre un autre condensateur 50 branché en parallèle sur les bornes du résonateur. Dans ces deux cas, on parvient ainsi à simplifier le procédé de fabrication puisqu'il n'est plus question de fabriquer une cellule de filtrage comportant deux résonateurs ayant des caractéristiques précises et légèrement décalées. En revanche, il faut bien l'admettre, comme on le voit dans la figure 3b, la courbe de réponse d'un tel quadripôle ne présente plus exactement le gabarit du filtre passe-bande recherché, et cela est un inconvénient majeur.

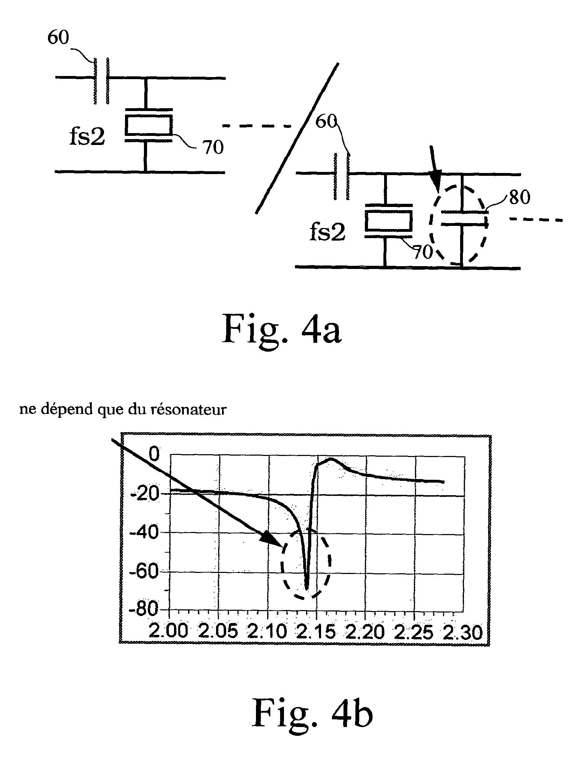

La figure 4a illustre la réalisation duale basée sur une capacité 60 sur la branche série, suivie d'un résonateur 70 sur la branche parallèle, quelque fois associé à un condensateur 80 en parallèle avec le resonateur. Il en résulte une autre cellule de filtrage dont la courbe est représentée en figure 4b.

Les circuits précédents, s'ils permettent d'éviter le problème de la fabrication d'un circuit intégré comportant deux résonateurs légèrement décalés, ne permettent pas la réalisation d'un filtre passe-bande satisfaisant et, si l'on souhaite obtenir les deux « zéros » caractéristiques de la fonction de transfert du filtre, il convient alors de revenir à la cellule classique de la figure 2a et des inconvénients qui en résultent.

Il serait souhaitable de pouvoir disposer d'une solution alternative, c'est à dire d'une cellule de filtrage simple à fabriquer et qui permette un profit adéquat pour la réalisation d'un filtre passe-bande facilement intégrable au sein d'un même produit semi-conducteur.

Tel est le problème à résoudre par la présente demande de brevet.

## Exposé de l'invention

La présente invention a pour but un circuit de filtrage passe-bande doté de résonateurs acoustiques qui sont faciles à intégrer au sein d'un même produit semi-conducteur.

Un autre but de la présente invention consiste à réaliser une structure de filtre passe-bande, facilement intégrable, dotée de deux résonateurs acoustiques, tels que des résonateurs BAW par exemple, qui résultent d'un même procédé de fabrication.

Un autre but de la présente invention consiste à proposer un procédé de fabrication simplifié d'un circuit intégré comportant un filtre passe-bande basés sur deux résonateurs BAW résultant d'un unique procédé de fabrication.

L'invention réalise ces buts au moyen d'une cellule de filtrage élémentaire basée sur un quadripôle comportant :

- sur sa branche serie, l'association en serie d'un premier resonateur acoustique et d'un premier condensateur ;
- sur sa branche parallele, l'association en parallele d'un deuxieme resonateur identique audit premier resonateur et d'un deuxieme condensateur identique audit premier condensateur.

Les deux résonateurs et les deux condensateurs étant parfaitement identiques, il en résulte que, et cela est remarquable, que la fréquence de résonance de la branche série coïncide avec la fréquence d'antirésonance de la branche parallèle. Elle se compense parfaitement et il en résulte que l'on peut alors réaliser un filtre passe-bande performant, et ce au moyen de deux résonateurs parfaitement identiques plus faciles à intégrer au sein d'un même produit semi conducteur.

De préférence les résonateurs seront des résonateurs de type BAW et l'on combinera une cascade de quadripôle identiques permettant la réalisation d'un filtre passe bande particulièrement performant.

Dans un mode de réalisation préféré, les résonateurs sont tous intégrés dans un même produit semi-conducteur, permettant ainsi la réalisation du filtre complètement intégré.

L'invention est particulièrement adapté à la réalisation d'un filtre de sélection de canaux en téléphonie mobile.

## Description des dessins

D'autres caractéristiques, but et avantages de l'invention apparaîtront à la lecture de la description et des dessins ci-après, donnés uniquement à titre d'examples non limitatifs. Sur les dessins annexés :

La figure 1 a est une courbe représentant le module de l'impédance en dB d'un résonateur acoustique de type BAW et met en évidence les deux fréquences de résonance et d'antirésonance.

La figure 1b illustre le schéma électrique équivalent d'un résonateur acoustique de type BAW.

La figure 2a illustre un filtre passe-bande élémentaire connu composé de deux résonateurs acoustiques respectivement en série et en parallèle.

La figure 2b illustre respectivement les courbes d'impédance (module de l'impédance en dB) et de gain (S21 en dB) du filtre de la figure 2a.

La figure 3a illustre un autre filtre élémentaire connu basé sur un résonateur en série et une capacité en parallèle.

La figure 3b illustre la courbe caractéristique du filtre de la figure 3a.

La figure 4a illustre un troisième filtre élémentaire connu basé sur une capacité en série et un résonateur en parallèle.

La figure 4b illustre la courbe caractéristique du filtre de la figure 4a.

La figure 5 illustre un circuit de filtrage passe-bande conforme à la présente invention.

La figure 6 illustre les courbes d'impédance des deux blocs résonateurs du circuit de la figure 5

La figure 7 montre la courbe caractéristique du filtre de la figure 5.

La figure 8 montre le détail des formules de calcul des fréquences de résonance et d'antirésonance pour chacun des blocs série (résonateur + capacité série) et parallèle (résonateur + capacité parallèle).

## Description d'un mode de réalisation préféré

On décrira à présent un mode de réalisation de l'invention en relation avec l'emploi de résonateurs BAW, lesquels présentent une meilleure aptitude à l'intégration en raison de la compatibilité avec le procédé de fabrication Very Large Scale Integration (VLSI). Clairement, il ne s'agit que d'un mode de réalisation particulier et un homme du métier pourra adapter l'invention à tous autres types de résonateurs acoustiques.

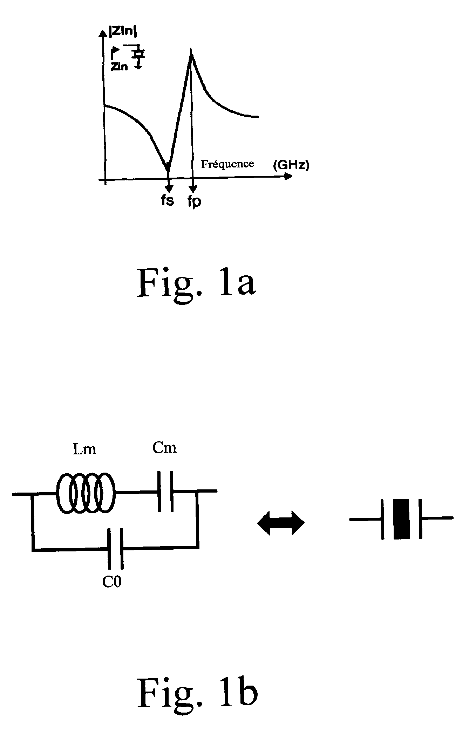

Les résonateurs acoustiques présentent deux fréquences de résonance très proches, respectivement fs (série) et fp (parallèle), comme cela est illustré dans la figure 1a. Si l'on se ramène à un schéma électrique équivalent présenté en figure 1b, cela revient à considérer deux circuits résonants de type LC, respectivement série et parallèle, avec les composants Lm, Cm, C0.

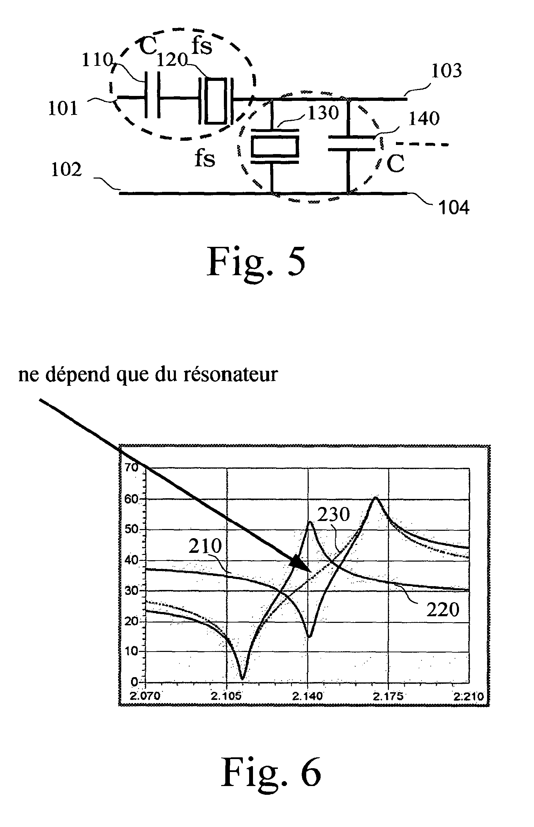

La figure 5 illustre le détail d'une cellule de filtrage passe-bande conforme à la présente invention. La cellule se présente sous la forme d'un quadripôle comportant deux entrées 101 et 102, deux sorties 103 et 104. L'entrée 101 est connectée à une première électrode d'un condensateur 110 dont une deuxième électrode est connectée à une première électrode d'un premier résonateur 120. Le résonateur 120 dispose d'une seconde électrode connectée à la sortie 103 de la cellule, mais également à une première électrode d'un second résonateur acoustique 130 et à une première électrode d'un second condensateur 140. Les secondes électrodes du résonateur 130 et du condensateur 140 sont connectées à l'entrée 102 ainsi qu'à la sortie 104 .

Comme on le constate, le couple formé par le résonateur 120 et le condensateur 110 est monté dans la branche série du quadripôle, tandis que le résonateur 130 et son condensateur associé 140 sont montés dans la branche parallèle de ce même quadripôle.

Les résonateurs acoustique 120 et 130 sont deux résonateurs de type BAW *(Bulk Acoustic Resonator)* qui sont issus du même procédé de fabrication afin d'assurer des caractéristiques électriques identiques. Bien que les résonateurs BAW présentent l'avantage de permettre une meilleure intégration au sein d'un produit semi-conducteur, il n'est pas exclu pour un homme du métier de réaliser la cellule de filtrage au moyen de deux résonateurs acoustiques de type SAW *(Surface Acoustic Resonator).*

De la même manière les condensateurs 110 et 140 sont choisies de manière à présenter une même valeur de capacité C. De préférence, on réalisera les deux condensateurs 110 et 140 au moyen de composants passifs afin de s'affranchir des phénomènes de bruit et des non linéarités engendrées par des composants actifs tels que les transistors. De cette manière, on obtient un filtre passif. Alternativement, les condensateurs 110 et 140 pourront être réalisés au moyen de capacités de jonction de transistors MOS.

On notera que les deux résonateurs 120 et 130 (fs) , puisqu'il sont par hypothèse identiques, sont bien plus faciles à réaliser que la cellule classique fondée sur deux résonateurs décalés. En particulier, il n'est pas nécessaire d'envisager une phase de dépôt d'une sur couche sur l'un des deux résonateurs, ni le rabotage éventuel de cette même sur couche par un laser *(dite « trimming* dans la littérature anglo-saxonne) pour assurer, d'une manière précise, l'épaisseur idoine de cette sur couche et parvenir ainsi au décalage souhaité entre les deux résonateurs BAW. Même lorsque l'on prévoira une étape dite de « trimming » , on notera alors que, puisque les résonateurs sont parfaitement identiques, cette étape de trimming affectera de manière identique chacun des deux résonateurs, ce que l'on ne pouvait réaliser dans la manière classiquement connue.

On s'est aperçu, et cela est une propriété remarquable mise à profit par la présente invention, que le condensateur 110 placé en série avec le résonateur 120 a pour effet de décaler la fréquence de résonance (ou fréquence série) de ce dernier.

Corrélativement, le condensateur 140, placé en parallèle sur le résonateur 130 a pour effet de décaler la fréquence d'anti-résonance (ou fréquence parallèle) de ce dernier.

Ce qui est encore plus remarquable, c'est que les décalages ainsi opérés conduisent à une fréquence intermédiaire, comme on peut le constater sur l'exemple de la figure 6 montrant cette fréquence intermédiaire 2.140 Ghz, qui est commune pour les deux résonateurs.

La figure 6 montre en effet tout particulièrement les courbes d'impédances des deux branches, respectivement celle de la branche série 110-120 (courbe 210) et celle de la branche parallèle 130-140 (courbe 220). La courbe 230 est la courbe d'impédance d'un résonateur seul (120 ou 130).

Cette propriété décisive se montre d'une manière formelle. En effet, s'agissant de la courbe 210 de la branche série 110-120, on peut montrer que les deux fréquences série (résonance) et parallèle (anti-résonance) sont données par les formules suivantes :

$$\omega_p = \sqrt{\frac{1}{Lm \times Cm}} \times \sqrt{\frac{Cm + C0}{C0}}$$

et

$$\omega_s = \sqrt{\frac{1}{Lm \times Cm}} \times \sqrt{\frac{Cm + C0 + C}{C0 + C}}$$

S'agissant de la courbe 220 de la branche parallèle 130-140, les deux fréquences série et parallèle sont données par les formules suivantes :

$$\omega_p = \sqrt{\frac{1}{Lm \times Cm}} \times \sqrt{\frac{Cm + C0 + C}{C0 + C}}$$

et

$$\omega_s = \sqrt{\frac{1}{Lm \times Cm}}$$

On retrouve ainsi que l'on a bien identité entre la fréquence série de la courbe 210 et la fréquence parallèle de la courbe 220. Comme on peut le voir sur la figure 6, la fréquence série de la courbe 210 et la fréquence parallèle de la courbe 220 s'avèrent être mathématiquement identiques lorsque les capacités 110 et 140 sont identiques.

En revanche , les fréquences parallèle de la branche série (courbe 210) et série de la branche parallèle (courbe 220) permettent de constituer les deux zéros assurant la réalisation du filtre passe-bande recherché. On notera que ces deux fréquences ne dépendent que des caractéristiques communes des deux résonateurs 120 et 130.

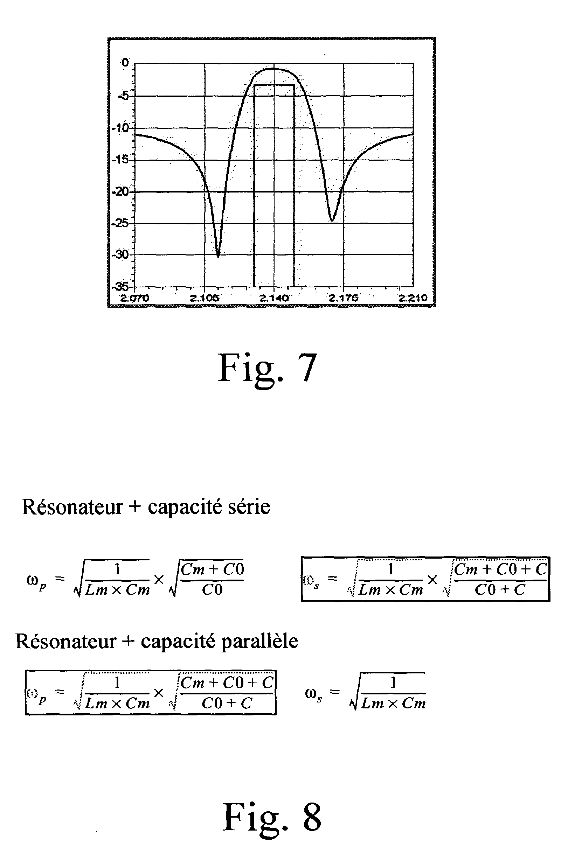

La figure 7 illustre la courbe de gain du filtre passe-bande réalisé au moyen du quadripôle de la figure 5, laquelle, comme on le voit, présente bien le gabarit recherché du filtre passe-bande. Les quadripôle de filtrage pourront être montés en cascade pour réaliser un filtre particulièrement performant.

## Revendications

1. Circuit de filtrage passe-bande basé sur un quadripôle comportant :

    - une branche série comportant un premier résonateur acoustique (120) présentant une fréquence de résonance et une fréquence d'anti-résonance et monté en série avec un premier condensateur (110) ;
    - une branche parallèle comportant un second résonateur acoustique (130) résultant du même procédé de fabrication que ledit premier résonateur et monté en parallèle avec un second condensateur (140) de valeur identique audit premier condensateur (110).

2. Circuit de filtrage selon la revendication 1 **caractérisé en ce qu'**il comporte une cascade.

3. Circuit selon la revendication 1 ou 2 **caractérisé en ce que** lesdits premier et second résonateur acoustiques sont des résonateurs de type BAW

4. Circuit selon la revendication 3 **caractérisé en ce que** les résonateurs BAW sont intégrés au sein d'un même produit semi-conducteur.

5. Circuit selon l'une quelconque des revendications précédentes **caractérisé en ce que** lesdits premier et second condensateurs sont réalisés au moyen de composants capacitifs de type passif.

6. Circuit selon l'une quelconque des revendications 1 à 4, **caractérisé en ce que** lesdits premier et second condensateurs sont réalisé au moyen de capacités de jonction MOS.

7. Téléphone mobile comportant un circuit de filtrage tel que défini dans l'une quelconque des revendications précédentes pour la sélection des canaux, le dit téléphone comportant un circuit de filtrage ayant un quadripôle comportant :

    - une branche série comportant un premier résonateur acoustique (120) présentant une fréquence de résonance et une fréquence d'anti-résonance et monté en série avec un premier condensateur (110) ;
    - une branche parallèle comportant un second résonateur acoustique (130) résultant du même procédé de fabrication que ledit premier résonateur et monté en parallèle avec un second condensateur (140) de valeur identique audit premier condensateur (110).

8. Récepteur d'un système de communication sans fil comportant un circuit de filtrage tel que défini dans l'une quelconques des revendications 1 à 6, le dit circuit comportant un circuit de filtrage ayant :.

    - une branche série comportant un premier résonateur acoustique (120) présentant une fréquence de résonance et une fréquence d'anti-résonance et monté en série avec un premier condensateur (110) ;
    - une branche parallèle comportant un second résonateur acoustique (130) résultant du même procédé de fabrication que ledit premier résonateur et monté en parallèle avec un second condensateur (140) de valeur identique audit

**EP 1 739 831 A1**

premier condensateur (110).

Fig. 1a

Fig. 1b

Fig. 2a

Fig. 2b

fs1

30

fs1

50

30

40

40

# Fig. 3a

0

-50

-100

-150

2.00 2.05 2.10 2.15 2.20 2.25 2.30

ne dépend que du résonateur

# Fig. 3b

60

fs2    70

60

fs2    70    80

## Fig. 4a

ne dépend que du résonateur

## Fig. 4b

Fig. 5

ne dépend que du résonateur

Fig. 6

# Fig. 7

Résonateur + capacité série

$$\omega_p = \sqrt{\frac{1}{Lm \times Cm}} \times \sqrt{\frac{Cm + C0}{C0}} \qquad \omega_s = \sqrt{\frac{1}{Lm \times Cm}} \times \sqrt{\frac{Cm + C0 + C}{C0 + C}}$$

Résonateur + capacité parallèle

$$\omega_p = \sqrt{\frac{1}{Lm \times Cm}} \times \sqrt{\frac{Cm + C0 + C}{C0 + C}} \qquad \omega_s = \sqrt{\frac{1}{Lm \times Cm}}$$

# Fig. 8

**Office européen
des brevets**

**RAPPORT DE RECHERCHE EUROPEENNE**

Numéro de la demande

EP 06 36 8010

## DOCUMENTS CONSIDERES COMME PERTINENTS

| Catégorie | Citation du document avec indication, en cas de besoin, des parties pertinentes | Revendication concernée | CLASSEMENT DE LA DEMANDE    (IPC) |
|---|---|---|---|
| A | US 3 697 903 A (FRANZ L. SAUERLAND) 10 octobre 1972 (1972-10-10) * figure 3a * ----- | 1-8 | INV. H03H9/64 H03H9/58 |

|  |  |  | DOMAINES TECHNIQUES RECHERCHES  (IPC) |
|---|---|---|---|
|  |  |  | H03H |

Le présent rapport a été établi pour toutes les revendications

| Lieu de la recherche | Date d'achèvement de la recherche | Examinateur |
|---|---|---|
| La Haye | 12 octobre 2006 | RADOMIRESCU, B |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
..........................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 06 36 8010

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-10-2006

| Document brevet cité au rapport de recherche | Date de publication | Membre(s) de la famille de brevet(s) | Date de publication |
|---|---|---|---|
| US 3697903 A | 10-10-1972 | DE 1925154 A1<br>FR 2008772 A5<br>GB 1272104 A | 21-05-1970<br>23-01-1970<br>26-04-1972 |

EPO FORM P0460

Pour tout renseignement concernant cette annexe : voir Journal Officiel de l'Office européen des brevets, No.12/82

**EP 1 739 831 A1**

**RÉFÉRENCES CITÉES DANS LA DESCRIPTION**

**Documents brevets cités dans la description**

- FR 0315480